# EUROPEAN PATENT APPLICATION

(11) **EP 2 672 178 A2**
(43) Date of publication of application: **11.12.2013**
(21) Application number: 13002899.6
(22) Date of filing: 05.06.2013
(51) Int. Cl.: F21V 29/00, F21V 9/16, F21V 13/04, G02B 27/00, F21V 7/22, F21V 15/01, F21Y 101/02

(54) **Light source apparatus and lighting apparatus**

(30) Priority: 08.06.2012 JP 2012130643
(71) Applicant: NITTO DENKO CORPORATION, Ibaraki-shi, Osaka 567-8680 (JP)
(72) Inventor: Shimizu, Hirokazu, Toyonaka-shi, Osaka, 560-0021 (JP); Taniuchi, Tetsuo, Sendai-shi, Miyagi, 982-0003 (JP); Fujita, Toshihiro, Osaka-shi, Osaka, 532-0004 (JP); Tokuda, Jun, Takarazuka-shi, Hyogo, 665-0811 (JP); Maeda, Shigeo, Osaka-shi, Osaka, 532-0004 (JP); Ito, Hisataka, Ibaraki-shi, Osaka, 567-8680 (JP); Katayama, Hiroyuki, Ibaraki-shi, Osaka, 567-8680 (JP)
(74) Representative: Müller-Boré & Partner Patentanwälte

(57) **Abstract**

A laser lighting module (1) includes a base part (21), a laser diode (11) which is a blue laser device, a substrate (12) with which the laser diode (11) is in contact, a ceramic phosphor (13) which reflects light entering from the laser diode to thereby change a direction of the light and is excited by the light to generate yellow fluorescence, and a lens (21) for adjusting luminous intensity distribution of light emitted from the ceramic phosphor(13). The substrate (12) is formed of a material which is thin and has excellent thermal conductivity, and is in surface contact with the laser diode (11) and the base part. In the laser lighting module (1), since the substrate (12) serves as a device heat radiator, it is possible to easily remove the heat generated by the laser diode (11).

## Description

### Technical Field

The present invention relates to a light source apparatus and a lighting apparatus.

### Background Art

In recent years, lighting apparatuses using LEDs (Light Emitting Diodes) as a light source have been used in offices, stores, and the like. On the other hand, a laser diode (LD) is used as a light source of an optical pickup of an optical drive, a laser beam printer, a laser pointer, and the like. For example, Japanese Patent Application Laid Open Gazette No. 2011-215531 (Document 1) discloses a projector including a light source which emits laser light. In the projector, a phosphor is disposed on an optical path between the light source and a cross dichroic prism. In a measurement endoscope disclosed in Japanese Patent Application Laid Open Gazette No. 2007-205918 (Document 2) and an internal measurement device disclosed in Japanese Patent Application Laid Open Gazette No. 2007-33298 (Document 3), a fluorescent material is disposed on a light outgoing surface of a prism upon which excitation light is incident. On the other hand, Japanese Patent Application Laid Open Gazette No. 2008-108553 (Document 4) proposes the use of a light emitting device using a laser diode as a light source, for lighting.

Actually, a laser diode generates a larger amount of heat than an LED in light emission. Further, since light emitted from the laser diode has a large amount of energy, a phosphor which generates fluorescence from the light of the laser diode deteriorates fast.

### Summary of Invention

The present invention is intended for a light source apparatus and a lighting apparatus, and it is an object of the present invention to easily remove heat generated by a laser device.

The light source apparatus according to the present invention includes a blue laser device for emitting blue laser light, a device heat radiator with which the blue laser device is in contact, a mirror for reflecting light entering from the blue laser device to change a direction of light, a phosphor excited by light from the blue laser device to generate fluorescence, and a luminous intensity distribution adjustment part for adjusting luminous intensity distribution of light emitted from the phosphor. By the present invention, it is possible to easily remove heat generated by the laser device.

In a preferred embodiment of the present invention, the phosphor is a prism-type phosphor which is a ceramic phosphor, and the mirror is a reflection surface of the prism-type phosphor.

Preferably, the light source apparatus further includes a band pass filter covering a light entrance surface of the prism-type phosphor, passing light from the blue laser device therethrough, and reflecting fluorescence from the prism-type phosphor.

In another preferred embodiment of the present invention, a light outgoing surface of the prism-type phosphor is curved, and the luminous intensity distribution adjustment part is the light outgoing surface of the prism-type phosphor.

In still another preferred embodiment of the present invention, the light source apparatus further includes a prism having the mirror as a reflection surface thereof, and in the light source apparatus of the present invention, light from the prism enters the phosphor.

Preferably, the light source apparatus further includes a band pass filter covering a light entrance surface of the phosphor, passing light from the prism therethrough, and reflecting fluorescence from the phosphor.

More preferably, the band pass filter also covers a side surface of the phosphor.

In yet another preferred embodiment of the present invention, the light source apparatus further includes a mirror heat radiator being in contact with the mirror.

In a further preferred embodiment of the present invention, the blue laser device is a blue LD chip.

The present invention is also intended for a lighting apparatus including the light source apparatus as defined above.

These and other objects, features, aspects and advantages of the present invention will become more apparent from the following detailed description of the present invention when taken in conjunction with the accompanying drawings.

### Brief Description of Drawings

Fig. 1 is a plan view showing a lighting apparatus in accordance with a first preferred embodiment of the present invention;
Fig. 2 is a side elevation showing the lighting apparatus;
Fig. 3 is a plan view showing a laser lighting module;
Fig. 4 is a partially sectional view showing the laser lighting module;
Fig. 5 is a plan view showing an LED lighting module;
Fig. 6 is a partially sectional view showing the LED lighting module;
Fig. 7 is a plan view showing a sensor module;
Fig. 8 is a partially sectional view showing the sensor module;
Fig. 9 is a partially sectional view showing another laser lighting module;
Fig. 10 is a plan view showing still another laser lighting module;
Fig. 11 is a partially sectional view showing yet another laser lighting module;
Fig. 12 is a partially sectional view showing still another laser lighting module;
Fig. 13 is a partially sectional view showing yet another laser lighting module;
Fig. 14 is a partially sectional view showing still another laser lighting module; and
Fig. 15 is a plan view showing a lighting apparatus in accordance with a second preferred embodiment of the present invention.

### Description of Embodiments

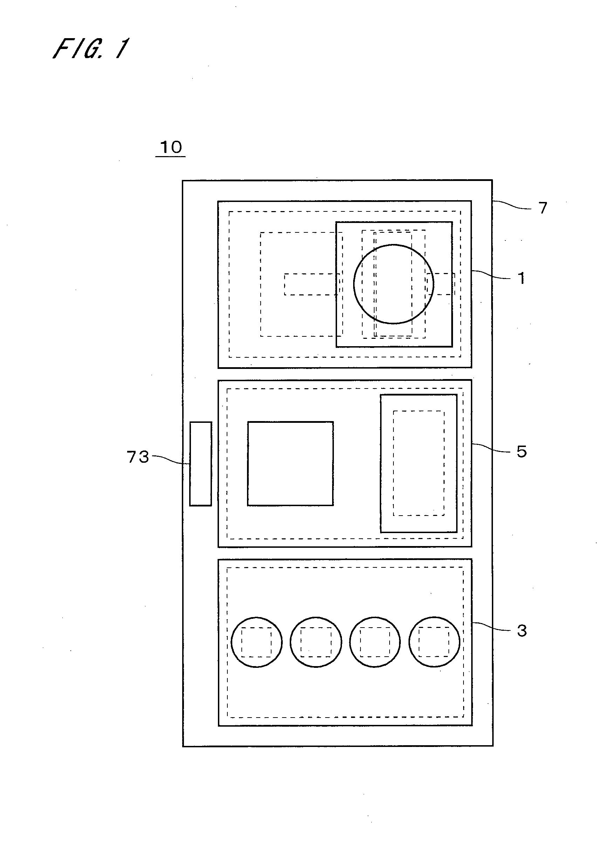

Fig. 1 is a plan view showing a lighting apparatus 10 in accordance with a first preferred embodiment of the present invention. The lighting apparatus 10 includes a laser lighting module 1, an LED (Light Emitting Diode) lighting module 3, and a sensor module 5. The lighting apparatus 10 further includes a mount body part 7 on which the laser lighting module 1, the LED lighting module 3, and the sensor module 5 can be removably mounted.

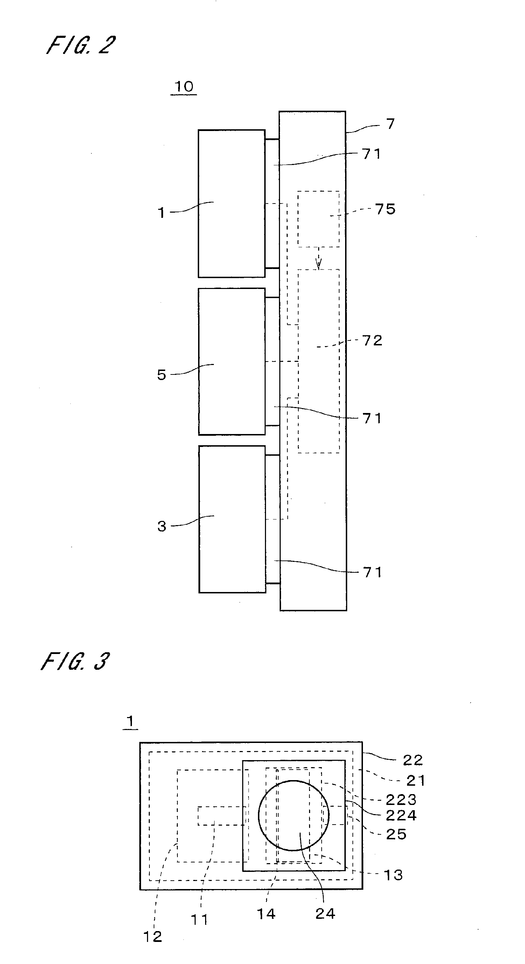

Fig. 2 is a side elevation showing the lighting apparatus 10. The mount body part 7 includes a plurality of (three, in the present preferred embodiment) module mount parts 71 on each of which any one of the laser lighting module 1, the LED lighting module 3, and the sensor module 5 can be mounted. The mount body part 7 further includes therein a common power supply 72 for commonly supplying the laser lighting module 1, the LED lighting module 3, and the sensor module 5 with electric power.

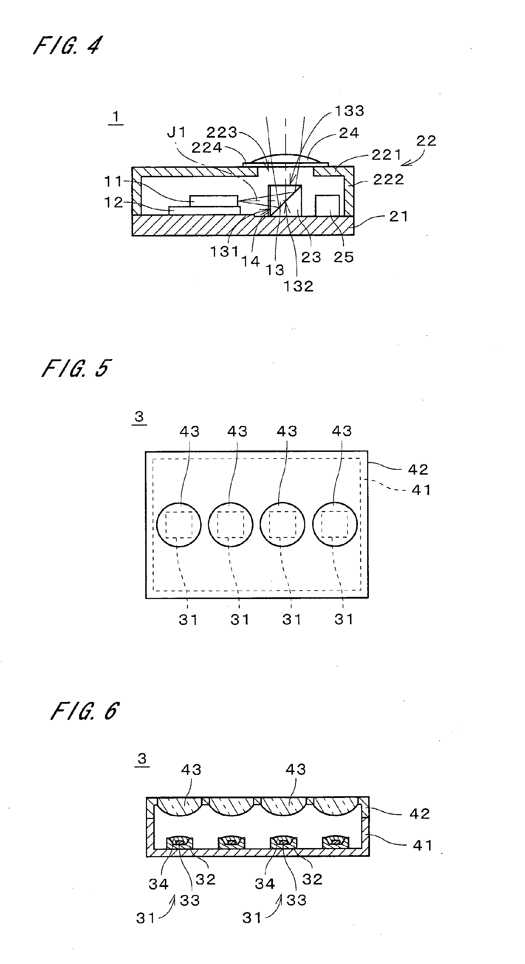

Fig. 3 is a plan view showing the laser lighting module 1. Fig. 4 is a partially sectional view showing an internal structure of the laser lighting module 1. Fig. 4 shows a cross section of a base part 21 and a cover 22 both of which are described later (the same applies to Figs. 6, 8, 9, 11 to 14). As shown in Figs. 3 and 4, the laser lighting module 1 includes a laser diode (LD) 11, a substrate 12 on which the laser diode 11 is mounted, a ceramic phosphor 13 upon which light emitted from the laser diode 11 is incident (emitted). The laser diode 11 is a blue laser device for emitting blue laser light, and is a bare chip of a blue laser diode in the present preferred embodiment.

The ceramic phosphor 13 is a phosphor which has transparency and is excited by the light from the laser diode 11 to generate yellow fluorescence. As a phosphor component of the ceramic phosphor, for example, a YAG-based phosphor is used but this is only one exemplary component (the same applies to the ceramic phosphor 13b described later). As shown in Fig. 4, the ceramic phosphor 13 is a prism-type phosphor which is an optical member having a shape of substantially triangle pole. In the ceramic phosphor 13, the three rectangular side surfaces of the triangle pole serve as a light entrance surface 131 upon which the light from the laser diode 11 is incident, a reflection surface 132 which totally reflects the light entering from the laser diode 11, a light outgoing surface 133 from which illumination light goes out, respectively. A cross section perpendicular to the light entrance surface 131, the reflection surface 132, and the light outgoing surface 133 of the ceramic phosphor 13 has a shape of isosceles right triangle, and the reflection surface 132 corresponds to an oblique surface described as a hypotenuse of the isosceles right triangle in Fig. 4. The ceramic phosphor 13 is disposed so that the light entrance surface 131 may be substantially perpendicular to an optical axis J1 of the light from the laser diode 11.

The laser lighting module 1 further includes a band pass filter 14 which covers the light entrance surface 131 of the ceramic phosphor 13. The band pass filter 14 passes the light from the laser diode 11 therethrough and reflects the fluorescence from the ceramic phosphor 13. The blue laser light from the laser diode 11 passes through the band pass filter 14, enters the ceramic phosphor 13, and then is reflected by the reflection surface 132, to be led to the light outgoing surface 133. In other words, the reflection surface 132 serves as a mirror which reflects the light entering from the laser diode 11, to thereby change a direction of the light. The fluorescence generated by the ceramic phosphor 13 is reflected by the band pass filter 14, to be efficiently led to the light outgoing surface 133. The light which is led to the light outgoing surface 133 goes out from the light outgoing surface 133 as illumination light of pseudo white. The band pass filter 14 may be so disposed as to also cover the surfaces on both (left and right) sides of the light entrance surface 131 of the ceramic phosphor 13 (in other words, two triangular surfaces of the triangle pole, i.e., the upper and lower surfaces of the triangle pole).

As shown in Figs. 3 and 4, the laser lighting module 1 further includes a plate-like base part 21 attached onto the mount body part 7 (see Figs. 1 and 2), a cover 22 covering an upper portion of the base part 21, a holding member 23 for holding the ceramic phosphor 13, a lens 24 serving as a luminous intensity distribution adjustment part for adjusting luminous intensity distribution (spread) of the illumination light, and a light receiving sensor 25 disposed on the opposite side of the laser diode 11 with the ceramic phosphor 13 interposed therebetween (in other words, disposed behind the reflection surface 132 of the ceramic phosphor 13 when viewed from the laser diode 11). The cover 22 includes a top portion 221 and a side wall portion 222 extending downward from an outer edge portion of the top portion 221. A lower portion of the side wall portion 222 is fastened to an outer edge portion of the base part 21. The base part 21 and the cover 22 are each formed of metal. The space formed by the base part 21 and the cover 22 is filled with nitrogen.

The substrate 12, the holding member 23, and the light receiving sensor 25 are disposed on the base part 21, and the laser diode 11 is mounted on the substrate 12 as discussed above. Further, the ceramic phosphor 13 and the band pass filter 14 are attached onto the holding member 23. In other words, the laser diode 11, and the ceramic phosphor 13 and the band pass filter 14 are disposed on the base part 21 with the substrate 12 and the holding member 23, respectively.

The substrate 12 is formed of a material which is thin and has excellent thermal conductivity. The substrate 12 is in surface contact with the laser diode 11 and the base part 21. Heat generated from the laser diode 11 is thereby efficiently radiated to the outside of the laser lighting module 1 through the substrate 12 and the base part 21. In other words, the substrate 12 serves as a device heat radiator which is in contact with the laser diode 11 to radiate the heat from the laser diode 11. The substrate 12 does not have to be exactly in surface contact with the laser diode 11 and the base part 21 but only have to be substantially in surface contact therewith.

The top portion 221 has an opening 223 positioned opposite to the light outgoing surface 133 of the ceramic phosphor 13, and the opening 223 is covered with a cover glass 224. The lens 24 is attached onto the cover glass 224 at such a position as to overlap the opening 223. The luminous intensity distribution of the illumination light going out from the ceramic phosphor 13 is adjusted when the illumination light passes through the lens 24. As the luminous intensity distribution adjustment part, a fly eye lens in which a lot of very small lenses are arranged, a substantial surface-like fresnel lens, or the like may be used, as well as the single lens 24.

The holding member 23 is a member having a shape of substantially triangle pole which is almost the same as that of the ceramic phosphor 13. A cross section perpendicular to the three rectangular side surfaces of the holding member 23 has a shape of substantially isosceles right triangle, and a side surface which corresponds to an oblique surface is in surface contact with the reflection surface 132 of the ceramic phosphor 13 and another side surface is in surface contact with the base part 21. The holding member 23 is formed of a material having thermal conductivity higher than that of the ceramic phosphor 13 and transparency, such as sapphire. Heat generated from the ceramic phosphor 13 is efficiently radiated to the outside of the laser lighting module 1 through the holding member 23 and the base part 21. In other words, the holding member 23 serves as a prism heat radiator which is in contact with the reflection surface 132 of the ceramic phosphor 13 which is the prism-type phosphor, and is regarded also as a mirror heat radiator since the holding member 23 is in contact with the reflection surface 132 which is the mirror. The holding member 23 does not have to be exactly in surface contact with the ceramic phosphor 13 and the base part 21 but only have to be substantially in surface contact therewith. Further, the holding member 23 having transparency may be formed of diamond, gallium nitride, transparent alumina ceramics, or the like, which has high thermal conductivity.

In the laser lighting module 1, light leaked from the reflection surface 132 of the ceramic phosphor 13, due to deterioration, damage, or the like of the ceramic phosphor 13, passes through the holding member 23 and is received by the light receiving sensor 25. An output of the light receiving sensor 25, i.e., the amount of light leaked from the ceramic phosphor 13 which is detected by the light receiving sensor 25, is transmitted to the substrate 12. Then, when the output of the light receiving sensor 25 becomes a predetermined threshold value or more, a control circuit serving as a device control part which is provided on the substrate 12 stops the driving of the laser diode 11.

In the laser lighting module 1, by providing the light receiving sensor 25, it becomes possible to easily grasp the state of the ceramic phosphor 13. Further, since the driving of the laser diode 11 is stopped on the basis of the output of the light receiving sensor 25, it is possible to prevent the laser light from being emitted to the ceramic phosphor 13 which is deteriorated or damaged to some degree. This increases the safety of the laser lighting module 1.

Fig. 5 is a plan view showing the LED lighting module 3. Fig. 6 is a partially sectional view showing an internal structure of the LED lighting module 3. As shown in Figs. 5 and 6, the LED lighting module 3 includes a base part 41 attached onto the mount body part 7, a cover 42 covering an upper portion of the base part 41, a plurality of LED devices 31 disposed on the base part 41, and a plurality of lenses 43 disposed on the cover 42, opposite to the plurality of LED devices 31. Each of the LED devices 31 includes a chip base 32 having a recessed portion at its upper portion, an LED chip 33 mounted in the recessed portion of the chip base 32, and a phosphor 34 filling the recessed portion of the chip base 32 to cover (seal) the LED chip 33, as shown in Fig. 6.

The LED chip 33 is a bare chip of a blue LED. The phosphor 34 has transparency and is excited by light from the LED chip 33 to generate yellow fluorescence. The phosphor 34 is formed by injecting a binder containing particles of the phosphor, such as silicon, into the recessed portion of the chip base 32 to thereby bind the particles. By mixing the blue light emitted from the LED chip 33 and the yellow light generated by the phosphor 34, illumination light of pseudo white is emitted from the LED device 31. The luminous intensity distribution of the illumination light emitted from the LED device 31 is adjusted when the illumination light passes through the lens 43 serving as the luminous intensity distribution adjustment part. Further, as the phosphor 34, the ceramic phosphor may be used.

A lighting range in a case where the LED lighting module 3 illuminates an object which is disposed a predetermined distance away from the LED lighting module 3 is wider than that in another case where the laser lighting module 1 illuminates an object which is disposed the same distance away from the laser lighting module 1.

The lighting apparatus 10 includes an illuminance sensor part 73 provided on the mount body part 7, for measuring the surrounding illuminance as shown in Fig. 1, and further includes an illumination control part 75 for controlling the laser lighting module 1 and the LED lighting module 3 on the basis of an output of the illuminance sensor part 73 as shown in Fig. 2. In the lighting apparatus 10, respective brightnesses of the laser lighting module 1 and the LED lighting module 3 are changed (controlled) on the basis of the output of the illuminance sensor part 73. Specifically, when the illuminance measured by the illuminance sensor part 73 is large, the illumination control part 75 controls the common power supply 72 to reduce the current to be supplied from the common power supply 72 to the laser lighting module 1 and the LED lighting module 3. The amount of illumination light from the laser lighting module 1 and the LED lighting module 3 is thereby reduced, and it is thus possible to achieve appropriate lighting in accordance with the surrounding illuminance. Further, the amount of illumination light from only one of the laser lighting module 1 and the LED lighting module 3 may be controlled on the basis of the output of the illuminance sensor part 73.

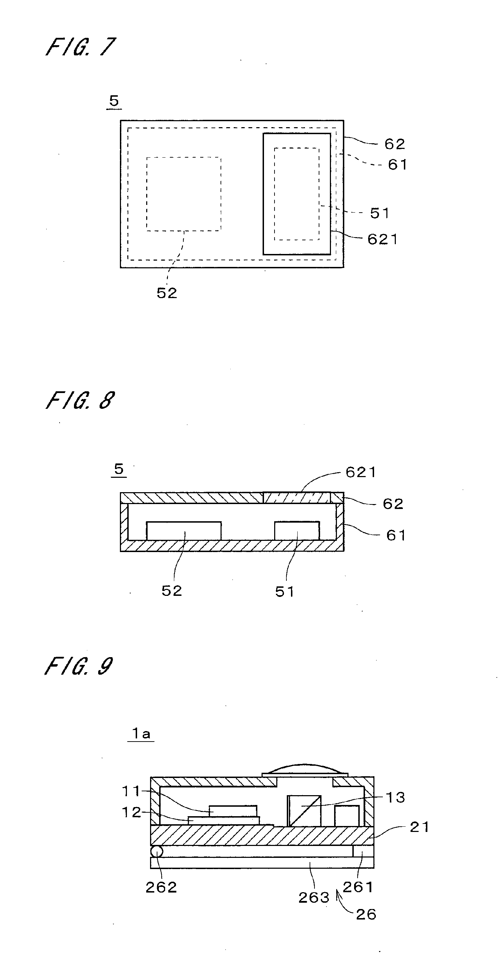

Fig. 7 is a plan view showing the sensor module 5. Fig. 8 is a partially sectional view showing an internal structure of the sensor module 5. As shown in Figs. 7 and 8, the sensor module 5 includes a base part 61 attached onto the mount body part 7, a cover 62 covering an upper portion of the base part 61, a motion sensor 51 disposed on the base part 61, and a sensor control part 52 for performing a control over the motion sensor 51. A cover glass 621 is provided on the cover 62, opposite to the motion sensor 51. The sensor module 5 detects the presence of a human in a predetermined sensing range. The motion sensor 51 is, for example, an ultrasonic or infrared sensor.

In this description, when the base part 21 of the laser lighting module 1, the base part 41 of the LED lighting module 3, and the base part 61 of the sensor module 5 need to be distinguished from one another, the base parts 21, 41, and 61 are referred to as a laser base part 21, an LED base part 41, and a sensor base part 61, respectively. Further, the ceramic phosphor 13 of the laser lighting module 1 is also referred to as a laser phosphor, and the phosphor 34 of the LED lighting module 3 is also referred to as an LED phosphor.

In the lighting apparatus 10 of Fig. 1, the respective brightnesses of the laser lighting module 1 and the LED lighting module 3 are changed (controlled) on the basis of the output of the sensor module 5. Specifically, when no presence of a human is detected in the sensing range of the sensor module 5, the sensor control part 52 controls the common power supply 72 to reduce the current to be supplied form the common power supply 72 to the laser lighting module 1 and the LED lighting module 3. It is thereby possible to appropriately reduce the amount of illumination light from the laser lighting module 1 and the LED lighting module 3. Further, the amount of illumination light from only one of the laser lighting module 1 and the LED lighting module 3 may be controlled on the basis of the output of the sensor module 5.

Though three module mount parts 71 are provided on the mount body part 7 in the lighting apparatus 10 of Fig. 1 (see Fig. 2), the number of module mount parts 71 is not limited to three but only has to be two or more. Then, by mounting one or a plurality of laser lighting modules 1 and one or a plurality of LED lighting modules 3 in various combinations on the mount body part 7 provided with the plurality of module mount parts 71, it is possible to manufacture lighting apparatuses for a variety of uses at low cost.

In the lighting apparatus 10, as discussed above, since a plurality of module mount parts 71 on each of which any one of the laser lighting module 1 and the LED lighting module 3 can be mounted are provided on the mount body part 7, it is possible to increase the degree of freedom in mounting the modules on the mount body part 7. Moreover, since the sensor module 5 can be mounted on the module mount part 71, it is possible to further increase the degree of freedom in mounting the modules on the mount body part 7. Furthermore, since the mount body part 7 includes the common power supply 72 for supplying the laser lighting module 1, the LED lighting module 3, and the sensor module 5 with electric power, it is possible to simplify the structure of the lighting apparatus 10.

As discussed above, though the sensor module 5 is a motion sensor part which is mounted on the mount body part 7 and serves as a motion sensor module, the motion sensor part may be incorporated in the mount body part 7 in the lighting apparatus 10. If the motion sensor part is the sensor module 5 which can be mounted removably on the mount body part 7 and this eliminates the necessity of providing the motion sensor part, the sensor module 5 can be omitted from the lighting apparatus 10 and this makes it possible to manufacture lighting apparatuses for a variety of uses at low cost.

In the laser lighting module 1 shown in Figs. 3 and 4, the bare chip of the blue laser diode is used as the laser diode 11. It is thereby possible to reduce the size of the laser diode 11. Further, since the substrate 12 on which the laser diode 11 is mounted serves as the device heat radiator, it is possible to easily remove the heat generated by the laser diode 11.

As discussed above, the ceramic phosphor 13 which is the prism-type phosphor is provided in the laser lighting module 1, and the reflection surface 132 of the ceramic phosphor 13 serves as the mirror for reflecting the light from the laser diode 11 to change the direction of the light. Thus, since both the generation of the fluorescence and the change in the direction of the light are performed in the ceramic phosphor 13, it is possible to simplify the structure of the laser lighting module 1. Further, since the structure to change the direction of the light from the laser diode 11 utilizes the total reflection by the ceramic phosphor 13, it is possible to suppress deterioration of the structure as compared with a case using a normal mirror (reflecting mirror).

In the laser lighting module 1, since the band pass filter 14 covering the light entrance surface 131 of the ceramic phosphor 13 is provided, it is possible to prevent the fluorescence generated by the ceramic phosphor 13 from going out from the light entrance surface 131 and efficiently lead the fluorescence to the light outgoing surface 133. As a result, it is possible to increase the use efficiency of the fluorescence from the ceramic phosphor 13. Further, since the cross section of the ceramic phosphor 13 has a shape of isosceles right triangle, even if the light entering the ceramic phosphor 13 from the laser diode 11 is shifted in a height direction (in a vertical direction of Fig. 4) to a certain degree, only if the light is incident upon the light entrance surface 131 at substantially right angle thereto, the optical path length of the light in the ceramic phosphor 13 (i.e., the optical path length from the light entrance surface 131 through the reflection surface 132 to the light outgoing surface 133) becomes almost constant. As a result, it is possible to suppress variation in the quality of the light going out from the ceramic phosphor 13.

Since the ceramic phosphor 13 has thermal conductivity higher than that of a general phosphor which is bound by using a binder, by holding the ceramic phosphor 13 by the holding member 23 which has high thermal conductivity (in other words, bringing the ceramic phosphor 13 into contact with the prism heat radiator), it is possible to efficiently remove the heat from the ceramic phosphor 13. As a result, it is possible to prevent the ceramic phosphor 13 and its surrounding components from becoming hot and increase the lifetime of the laser lighting module 1.

Next, discussion will be made on another preferable example of a laser lighting module. Fig. 9 is a partially sectional view showing an internal structure of another laser lighting module 1a having a constitution different from that of the laser lighting module 1. The laser lighting module 1a is provided with a lighting direction changing part 26 for changing an outgoing direction of illumination light. Other constituent elements are almost identical to those of the laser lighting module 1 shown in Figs. 3 and 4, and in the following discussion, the corresponding constituent elements will be represented by the same reference signs.

As shown in Fig. 9, the lighting direction changing part 26 is provided on a bottom surface of the base part 21 (in other words, provided on a surface opposite to the surface on which the laser diode 11 and the substrate 12 are provided). The laser lighting module 1a is attached onto the mount body part 7 (see Fig. 1) at the lighting direction changing part 26. The lighting direction changing part 26 includes a feed mechanism 261 connected to one end of the base part 21 in a horizontal direction of Fig. 9, a fulcrum 262 for supporting the other end of the base part 21, and a support part 263 for supporting the feed mechanism 261 and the fulcrum 262. The feed mechanism 261 is constituted of a motor and a screw mechanism. In the laser lighting module 1a, the feed mechanism 261 changes the distance between the one end of the base part 21 and the support part 263, to thereby rotate the base part 21 about the fulcrum 262. The outgoing direction of the illumination light from the laser lighting module 1a is thereby changed. As the lighting direction changing part, for example, a mechanism for changing the gradient of the ceramic phosphor 13 in the laser lighting module 1a may be provided. Thus, by providing the lighting direction changing part, it is possible to easily illuminate only a portion (space or location) that needs to be lightened, by using the laser lighting module 1a.

In a case where the laser lighting module 1a is provided in the lighting apparatus 10, the lighting direction changing part 26 in the laser lighting module 1a is controlled on the basis of the output of the sensor module 5 (see Fig. 1), to thereby change the lighting direction of the laser lighting module 1a. Specifically, the gradient of the base part 21 is changed by the lighting direction changing part 26 so that the laser lighting module 1a may illuminate an area around a human (for example, an area around the feet of the human) detected by the sensor module 5, to thereby change the outgoing direction of the illumination light from the laser lighting module 1a. It is thereby possible to automatically change the lighting direction of the laser lighting module 1a in accordance with the movement of a human.

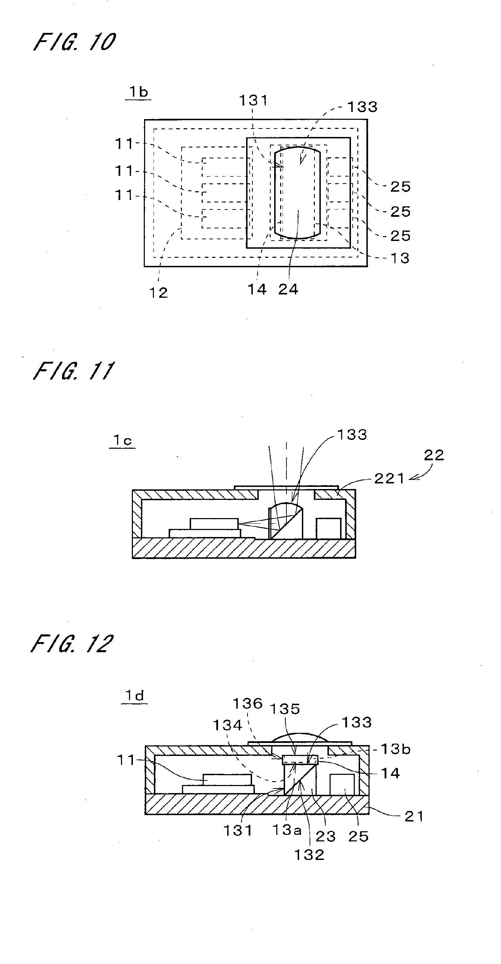

Fig. 10 is a plan view showing still another laser lighting module 1b. In the laser lighting module 1b, a plurality of laser diodes 11 are mounted on the substrate 12, and a plurality of light receiving sensors 25 are disposed on the opposite side of the plurality of laser diodes 11 with the ceramic phosphor 13 interposed therebetween. Other constituent elements are almost identical to those of the laser lighting module 1 shown in Figs. 3 and 4, and in the following discussion, the corresponding constituent elements will be represented by the same reference signs.

In the laser lighting module 1b, a plurality of (three, in the exemplary case of Fig. 10) laser diodes 11 are arranged in a direction parallel with the light entrance surface 131 of the ceramic phosphor 13, opposite to the light entrance surface 131. Blue laser light emitted from each of the three laser diodes 11 passes through the band pass filter 14, enters the ceramic phosphor 13, and then is reflected by the reflection surface 132 (see Fig. 4), to be led to the light outgoing surface 133. The fluorescence generated by the ceramic phosphor 13 is reflected by the band pass filter 14, to be efficiently led to the light outgoing surface 133. The light which is led to the light outgoing surface 133 goes out through the lens 24 as illumination light of pseudo white.

In the laser lighting module 1b, by providing a plurality of laser diodes 11, it is possible to easily increase the brightness of the illumination light. Further, by using the bare chips of the blue laser diodes as the plurality of laser diodes 11, it is possible to prevent upsizing of the laser lighting module 1b.

In the laser lighting module 1b, the light receiving sensor 25 is disposed opposite to each of the laser diodes 11 with the ceramic phosphor 13 interposed therebetween. Like in the laser lighting module 1 shown in Figs. 3 and 4, light leaked from the reflection surface 132 of the ceramic phosphor 13, due to deterioration or the like of the ceramic phosphor 13, passes through the holding member 23 (see Fig. 4) and is received by the light receiving sensor 25. When the output of the light receiving sensor 25 becomes a predetermined threshold value or more, the driving of the laser diode 11 corresponding to the light receiving sensor 25 is stopped. It is thereby possible to easily grasp the state of the ceramic phosphor 13 and increase the safety of the laser lighting module 1b.

Fig. 11 is a partially sectional view showing an internal structure of yet another laser lighting module 1c. In the laser lighting module 1c, the light outgoing surface 133 of the ceramic phosphor 13 is a curved surface which is convex toward the top portion 221 of the cover 22 and the lens on the cover 22 is omitted. Other constituent elements are almost identical to those of the laser lighting module 1 shown in Figs. 3 and 4, and in the following discussion, the corresponding constituent elements will be represented by the same reference signs.

In the laser lighting module 1c, the light outgoing surface 133 of the ceramic phosphor 13 serves as a luminous intensity distribution adjustment part, and the luminous intensity distribution of the illumination light going out from the ceramic phosphor 13 is adjusted when the illumination light passes through the light outgoing surface 133. As discussed above, since this eliminates the necessity of providing a lens serving as the luminous intensity distribution adjustment part on the cover 22, it is possible to simplify the structure of the laser lighting module 1c.

Fig. 12 is a partially sectional view showing an internal structure of still another laser lighting module 1d. The laser lighting module 1d is provided with a prism 13a having almost the same shape as that of the ceramic phosphor 13, instead of the ceramic phosphor 13 showing in Figs. 3 and 4. The band pass filter 14 is attached onto a light outgoing surface 133 of the prism 13a and a rectangular plate-like ceramic phosphor 13b is attached onto the band pass filter 14. Other constituent elements are almost identical to those of the laser lighting module 1 shown in Figs. 3 and 4, and in the following discussion, the corresponding constituent elements will be represented by the same reference signs.

Like the ceramic phosphor 13 shown in Figs. 3 and 4, the prism 13a includes a light entrance surface 131, a reflection surface 132, and a light outgoing surface 133, and a cross section perpendicular to these surfaces has a shape of substantially isosceles right triangle. The prism 13a is formed of ceramics having transparency, substantially not containing particles of the phosphor. The band pass filter 14 covers a lower main surface 134 of the ceramic phosphor 13b in Fig. 12, i.e., a main surface 134 opposite to the light outgoing surface 133 of the prism 13a. Further, the band pass filter 14 also covers four side surfaces 136 of the ceramic phosphor 13b.

The blue laser light emitted from the laser diode 11 enters the light entrance surface 131 of the prism 13a and is almost totally reflected by the reflection surface 132 serving as a mirror, to be led to the light outgoing surface 133. The blue laser light going out from the light outgoing surface 133 of the prism 13a passes through the band pass filter 14 and enters the lower main surface 134 of the ceramic phosphor 13b, to be led to an upper main surface 135. In the following discussion, the lower main surface 134 of the ceramic phosphor 13b in Fig. 12 is referred to as a "light entrance surface 134" and the upper main surface 135 in Fig. 12 is referred to as a "light outgoing surface 135". Fluorescence generated by the ceramic phosphor 13b is reflected by the band pass filter 14, to be efficiently led to the light outgoing surface 135. The light which is led to the light outgoing surface 135 goes out from the light outgoing surface 135 as illumination light of pseudo white.

In the laser lighting module 1d, since the structure to change the direction of the light from the laser diode 11 utilizes the total reflection by the prism 13a, it is possible to suppress deterioration of the structure. Further, since the band pass filter 14 covering the light entrance surface 134 of the ceramic phosphor 13b is provided, it is possible to prevent the fluorescence generated by the ceramic phosphor 13b from going out from the light entrance surface 134 and efficiently lead the fluorescence to the light outgoing surface 135. As a result, it is possible to increase the use efficiency of the fluorescence from the ceramic phosphor 13b. Further, since the side surfaces 136 of the ceramic phosphor 13b are covered by the band pass filter 14, it is possible to prevent the fluorescence from going out from the side surfaces 136 and further increase the use efficiency of the fluorescence from the ceramic phosphor 13b.

In the laser lighting module 1d, since the cross section of the prism 13a has a shape of substantially isosceles right triangle, even if the light entering the prism 13a from the laser diode 11 is shifted in a height direction (in a vertical direction of Fig. 12) to a certain degree, only if the light is incident upon the light entrance surface 131 at substantially right angle thereto, the optical path length of the light in the prism 13a becomes almost constant.

In the laser lighting module 1d, like in the laser lighting module 1 shown in Figs. 3 and 4, the holding member 23 which is a prism heat radiator having a shape of substantially triangle pole is provided on the base part 21 and the prism 13a is held by the holding member 23. The holding member 23 is formed of a material having thermal conductivity higher than that of the prism 13a and transparency, such as sapphire. Heat generated from the prism 13a and the ceramic phosphor 13b is efficiently radiated to the outside of the laser lighting module 1d through the holding member 23 and the base part 21. It is thereby possible to prevent an increase in the temperature of the prism 13a and the ceramic phosphor 13b. Further, the holding member 23 having transparency may be formed of diamond, gallium nitride, transparent alumina ceramics, or the like, which has high thermal conductivity.

In the laser lighting module 1d, further, the light receiving sensor 25 is provided on the opposite side of the laser diode 11 with the prism 13a interposed therebetween. Like in the laser lighting module 1 shown in Figs. 3 and 4, light leaked from the reflection surface 132 of the prism 13a, due to deterioration or the like of the prism 13a, passes through the holding member 23 and is received by the light receiving sensor 25. When the output of the light receiving sensor 25 becomes a predetermined threshold value or more, the driving of the laser diode 11 is stopped. As a result, it is possible to easily grasp the state of the prism 13a and increase the safety of the laser lighting module 1d.

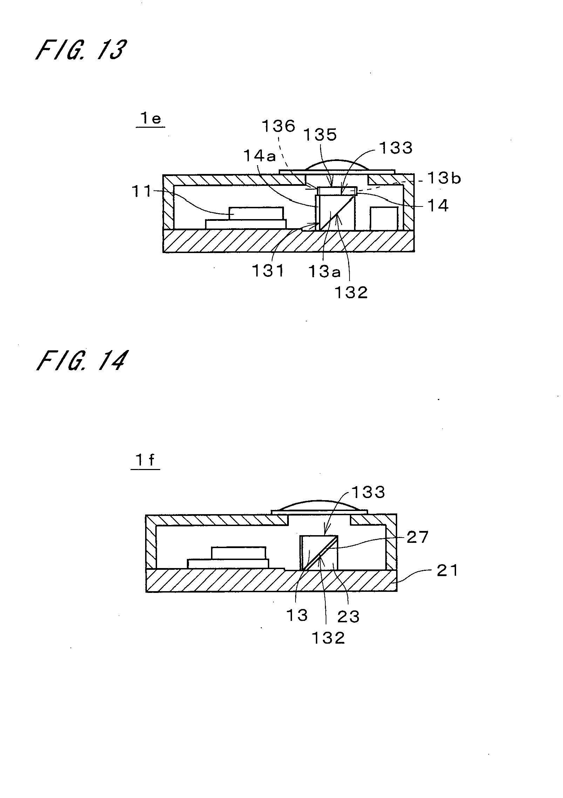

Fig. 13 is a partially sectional view showing an internal structure of yet another laser lighting module 1e. In the laser lighting module 1e, the ceramic phosphor 13b of the laser lighting module 1d shown in Fig. 12 is attached directly on the light outgoing surface 133 of the prism 13a and the four side surfaces 136 of the ceramic phosphor 13b are covered by the band pass filter 14. Further, a thin plate-like band pass filter 14a is attached directly on the light entrance surface 131 of the prism 13a. Other constituent elements are almost identical to those of the laser lighting module 1d shown in Fig. 12, and in the following discussion, the corresponding constituent elements will be represented by the same reference signs.

In the laser lighting module 1e, the band pass filter 14a covers the light entrance surface 131 of the prism 13a and passes the blue laser light emitted from the laser diode 11 therethrough. The light passing through the band pass filter 14a enters the light entrance surface 131 of the prism 13a and is almost totally reflected by the reflection surface 132, to be led to the light outgoing surface 133. Then, the light passes through the ceramic phosphor 13b which is so disposed as to be in contact with the light outgoing surface 133 of the prism 13a, to be led to the light outgoing surface 135 of the ceramic phosphor 13b. Fluorescence generated by the ceramic phosphor 13b is reflected by the band pass filter 14 covering the side surfaces 136, to be efficiently led to the light outgoing surface 135. Further, the fluorescence entering the prism 13a from the ceramic phosphor 13b to be led to the light entrance surface 131 of the prism 13a is reflected by the band pass filter 14a covering the light entrance surface 131 of the prism 13a, to be efficiently led to the light outgoing surface 135 of the ceramic phosphor 13b through the prism 13a. The light which is led to the light outgoing surface 135 goes out from the light outgoing surface 135 as illumination light of pseudo white.

In the laser lighting module 1e, like in the laser lighting module 1d of Fig. 12, by utilizing the total reflection by the prism 13a, it is possible to suppress deterioration of the structure to change the direction of the light from the laser diode 11. Further, since the band pass filter 14a covering the light entrance surface 131 of the prism 13a is provided, it is possible to increase the use efficiency of the fluorescence from the ceramic phosphor 13b. Furthermore, since the side surfaces 136 are covered by the band pass filter 14, it is possible to further increase the use efficiency of the fluorescence from the ceramic phosphor 13b.

Fig. 14 is a partially sectional view showing an internal structure of still another laser lighting module 1f. The laser lighting module If is provided with a thin plate-like reflector 27 between the reflection surface 132 of the ceramic phosphor 13 and the holding member 23 and the light receiving sensor 25 is omitted. Other constituent elements are almost identical to those of the laser lighting module 1 shown in Figs. 3 and 4, and in the following discussion, the corresponding constituent elements will be represented by the same reference signs.

In the laser lighting module If, the reflector 27 formed of metal or the like is substantially in surface contact with the reflection surface 132 of the ceramic phosphor 13 and the holding member 23. The efficiency of reflection of the fluorescence on the reflection surface 132 is thereby increased, and the fluorescence is more efficiently led to the light outgoing surface 133. As a result, it is possible to further increase the use efficiency of the fluorescence from the ceramic phosphor 13. In the laser lighting module 1f, heat generated from the ceramic phosphor 13 is efficiently radiated to the outside of the laser lighting module 1f through the reflector 27, the holding member 23 and the base part 21. Further, the holding member 23 may be formed of another material having no transparency, such as metal, ceramics, or the like. The holding member 23 is formed of, for example, silver, copper, aluminum, silicon, aluminum nitride, brass, carbon nanotube (CNT), or a composite material containing carbon nanotube.

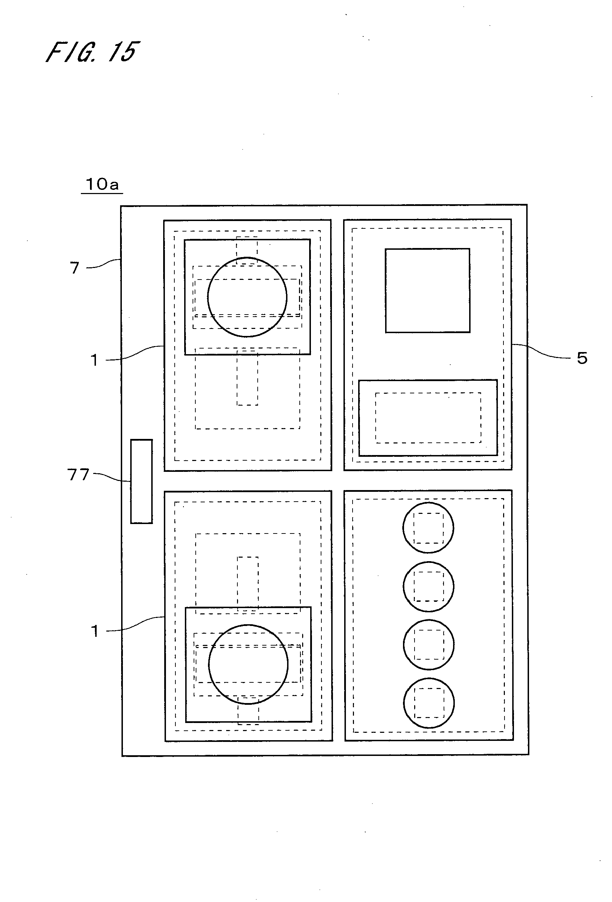

Next, discussion will be made on a lighting apparatus in accordance with a second preferred embodiment of the present invention. Fig. 15 is a plan view showing a lighting apparatus 10a in accordance with the second preferred embodiment of the present invention. As shown in Fig. 15, in the lighting apparatus 10a, four module mount parts 71 (see Fig. 2) are provided on the mount body part 7 and another laser lighting module 1 is mounted on the mount body part 7. Further, a light-up control part 77 is provided on the mount body part 7. Other constituent elements are almost identical to those of the lighting apparatus 10 shown in Fig. 1, and in the following discussion, the corresponding constituent elements will be represented by the same reference signs.

The two laser lighting modules 1 have the same structure. The lighting direction of one laser lighting module 1 and the lighting direction of the other laser lighting module 1 are different from each other. In the lighting apparatus 10a, the light-up control part 77 individually controls light-up of one laser lighting module 1 and that of the other laser lighting module 1 on the basis of the output of the sensor module 5.

Specifically, when the sensor module 5 detects that there is a human in a lighting range of one laser lighting module 1, the laser lighting module 1 is lit by the control of the light-up control part 77. Further, when the sensor module 5 detects that there is a human in a lighting range of the other laser lighting module 1, the other laser lighting module 1 is lit by the control of the light-up control part 77. When the sensor module 5 detects that there is no human in the lighting range of each of the laser lighting modules 1, the laser lighting modules 1 are extinguished by the control of the light-up control part 77. In the lighting apparatus 10a, by the control of the light-up control part 77, both the two laser lighting modules 1 may be lit or extinguished, or either one may be lit. It is thereby possible to efficiently light up a plurality of portions (locations) with a simple structure.

Though the preferred embodiments of the present invention have been discussed above, the present invention is not limited to the above-discussed preferred embodiments, but allows various variations.

In the above-discussed laser lighting module, for example, a so-called can-type blue laser device may be used as the laser diode 11. Also in this case, heat generated from the blue laser device is radiated to the outside through a device heat radiator which is in contact with the blue laser device. Further, in the laser lighting module having the lighting direction changing part, the lighting direction of the laser lighting module may be changed by a manual work of an operator when the lighting direction is set in installing the lighting apparatus 10.

The mirror which is a structure to reflect light from the blue laser device to thereby change the direction of the light is not necessarily the reflection surface 132 of the prism-type ceramic phosphor 13 or the reflection surface 132 of the prism 13a but may be, for example, an ordinary reflecting mirror. Further, a phosphor other than the ceramic phosphor, for example, a phosphor formed by binding particles of phosphor with a binder such as silicon or the like may be used.

In the above-discussed lighting apparatus, only if at least one laser lighting module is mounted on the mount body part 7, other modules may be changed or omitted as appropriate. Further, the laser lighting module may be used as a light source apparatus of another apparatus other than the lighting apparatus. Also in this case, as discussed above, by using the substrate 12 on which the laser diode 11 is mounted as a device heat radiator, it is possible to easily remove the heat generated by the laser diode 11.

The configurations in the above-discussed preferred embodiments and variations may be combined as appropriate only if those do not conflict with one another.

While the invention has been shown and described in detail, the foregoing description is in all aspects illustrative and not restrictive. It is therefore understood that numerous modifications and variations can be devised without departing from the scope of the invention.

### Reference Signs List

- 1, 1a - 1f: Laser lighting module
- 11: Laser diode (LD)
- 12: Substrate
- 13, 13b: Ceramic phosphor
- 13a: Prism
- 14, 14a: Band pass filter
- 23: Holding member
- 24: Lens
- 25: Light receiving sensor
- 131: Light entrance surface
- 132: Reflection surface
- 133: Light outgoing surface
- 134: Light entrance surface
- 136: Side surface

## Claims

1. A light source apparatus (1, 1a - 1f), comprising:
a blue laser device (11) for emitting blue laser light;
a mirror (132) for reflecting light entering from said blue laser device to change a direction of light;
a phosphor (13, 13b) excited by light from said blue laser device to generate fluorescence; and
a luminous intensity distribution adjustment part (24) for adjusting luminous intensity distribution of light emitted from said phosphor, and
**characterized in that**,
said light source apparatus further comprises a device heat radiator (12) with which said blue laser device is in contact.

2. The light source apparatus according to claim 1, wherein
said phosphor is a prism-type phosphor which is a ceramic phosphor, and
said mirror is a reflection surface of said prism-type phosphor.

3. The light source apparatus according to claim 2, further comprising:
a band pass filter (14) covering a light entrance surface (131) of said prism-type phosphor, passing light from said blue laser device therethrough, and reflecting fluorescence from said prism-type phosphor.

4. The light source apparatus according to claim 2 or 3, wherein
a cross-sectional surface perpendicular to said reflection surface of said prism-type phosphor has a shape of isosceles right triangle.

5. The light source apparatus according to claim 2 or 3, wherein
a light outgoing surface (133) of said prism-type phosphor is curved, and
said luminous intensity distribution adjustment part is said light outgoing surface of said prism-type phosphor.

6. The light source apparatus according to claim 1, further comprising:
a prism (13a) having said mirror as a reflection surface (132) thereof,
wherein light from said prism enters said phosphor.

7. The light source apparatus according to claim 6, further comprising:
a band pass filter (14) covering a light entrance surface (134) of said phosphor, passing light from said prism therethrough, and reflecting fluorescence from said phosphor.

8. The light source apparatus according to claim 7, wherein
said band pass filter also covers a side surface (136) of said phosphor.

9. The light source apparatus according to claim 6, further comprising:
a band pass filter (14a) covering a light entrance surface (131) of said prism,
wherein said phosphor is disposed, being in contact with a light outgoing surface (133) of said prism, and
said band pass filter passes light from said blue laser device therethrough and reflects fluorescence which enters said prism from said phosphor, being led to said light entrance surface of said prism.

10. The light source apparatus according to any one of claims 6 to 9, wherein a cross-sectional surface perpendicular to said reflection surface of said prism has a shape of isosceles right triangle.

11. The light source apparatus according to any one of claims 1 to 10, further comprising:
a mirror heat radiator (23) being in contact with said mirror.

12. The light source apparatus according to any one of claims 1 to 11, further comprising:
a light receiving sensor (25) disposed behind said mirror when viewed from said blue laser device, for receiving light leaked from said mirror.

13. The light source apparatus according to claim 12, wherein
driving of said blue laser device is stopped on the basis of an output from said light receiving sensor.

14. The light source apparatus according to any one of claims 1 to 13, wherein said blue laser device is a blue LD chip.

15. The light source apparatus according to claim 14, further comprising:
another blue LD chip for emitting blue laser light.

16. A lighting apparatus, comprising:
said light source apparatus according to any one of claims 1 to 15.
